Europäisches Patentamt

(19) European Patent Office

Office européen des brevets

(11) Publication number: 0 402 053 A2

## (12) EUROPEAN PATENT APPLICATION

(21) Application number: 90305962.4

(22) Date of filing: 31.05.90

(51) Int. Cl.5: **H01P 3/08, H01P 11/00**

(30) Priority: 05.06.89 GB 8912807

(43) Date of publication of application:
12.12.90 Bulletin 90/50

(84) Designated Contracting States:
AT BE CH DE DK ES FR GB GR IT LI LU NL SE

(71) Applicant: **GEC-MARCONI LIMITED**
**The Grove Warren Lane**
**Stanmore Middlesex HA7 4LY(GB)**

(72) Inventor: **Macleod, Angus James Miller**
**Gadebrook, Hydewood Lane**
**Canewdon, Essex SS4 3RR(GB)**

(74) Representative: **Tolfree, Roger Keith et al**
**The General Electric Co. p.l.c. Patent**
**Department GEC-Marconi Research Centre**
**West Hanningfield Road**
**Great Baddow, Chelmsford Essex CM2**
**8HN(GB)**

(54) Signal carrier supports.

(57) This invention relates to the support of Signal Carriers particularly in triplate centre conductors.

Presently dielectric insulators are used, and take the form of flat sheets. These have to be of uniform thickness and be machined to the required shape. This is expensive and often produces difficult to dispose of waste products.

These problems are overcome by the use of the present invention wherein an ordered layer of uniform spheres 9 of dielectric material, are placed about the conductor 3 to support it, the separation being dependent on the diameter ot the spheres (9).

Fig.2F.

EP 0 402 053 A2

## SIGNAL CARRIER SUPPORTS

This invention relates to supports for signal carriers, and particularly to supports for triplate centre conductors.

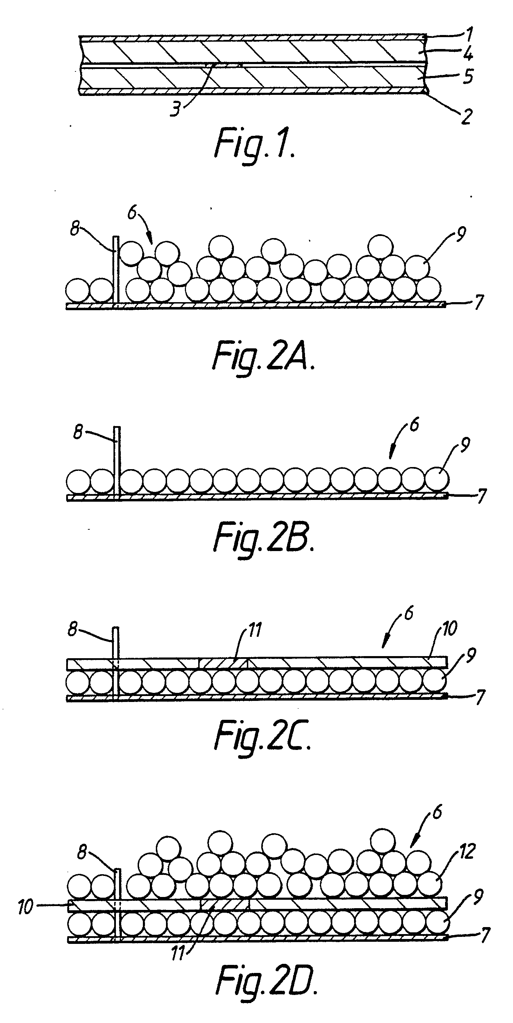

A typical known triplate is shown in Figure 1. It comprises a pair of parallel conductive ground planes 1 and 2 and a central conductor 3 between and parallel to them.

The central conductor 3 is held in position by being sandwiched between two dielectric sheets 4 and 5, typically having a thickness in the range 0.5mm to 5mm. The sheets 4 and 5 are secured to the ground planes 1 and 2 and are equal in thickness to ensure that the central conductor 3 is held equidistant from the two ground planes 1 and 2.

There are a number of problems with such a triplate structure. Firstly it is very difficult to produce dielectric sheets having a constant thickness over the large areas required in triplate feed structures. It is also necessary to shape or cut the dielectric sheets into the shape of the triplate structure and to cut holes in the dielectric sheets to allow spacers to be placed between the ground planes, this can be very difficult with some dielectrics which are too fragile to be easily handled and crumble to hazardous dust when machined, and in addition the expense of some dielectric materials makes the wastage produced by this machining a problem. Reducing the weight of the completed triplate is generally desirable and the weight of the sheets of dielectric material can be a significant proportion of the total weight of the triplate structure.

Stripline structures suffer from similar problems, being formed from a conductive ground plane spaced from and parallel to a signal carrying conductor, the two conductors being separated by a dielectric sheet.

This invention was intended to produce a signal carrier structure at least partially overcoming these problems.

This invention provides a signal carrier comprising a first conductor and a second conductor separated by a first layer of dielectric spheres, all the spheres being of equal diameter.

The use of spheres of equal diameter allows the separation of the two conductors to be kept constant over a large area more easily than by a dielectric sheet, also the spheres are easier to handle than large sheets of dielectric. Most dielectric materials can easily be formed as spheres and the use of a layer of spheres of equal diameter avoids the need to machine the dielectric, thus reducing waste and making assembly cheaper.

It will be appreciated that by the term sphere it is meant any substantially spherical body including such bodies having a large number of facets.

The weight of the finished assembly will be reduced because a layer of spheres has approximately 52% of the volume of material of a solid layer of the same thickness, and will therefore have only 52% of the weight.

A preferred method of carrying out the invention will now be described by way of example only with reference to the accompanying Figures in which:

Figures 2A to 2F show cross sections of stages in the production of a triplate feed according to the invention by a first method;

Figure 3 shows a cross section of a strip line feed made according to the invention; and

Figures 4A to 4C show cross sections of stages in the production of a triplate feed according to the invention by a second method, identical parts having the same reference numerals throughout.

Referring to Figure 2A the first stage in constructing a triplate structure 6 is shown. A ground plane is formed by a conductive plate 7, which bears a support 8 to support other parts of the triplate structure, as will be explained later, A number of dielectric spheres 9 all having the same diameter and coated with an ultra-violet curing adhesive are then dropped onto the conductive plate 7. These spheres 9 will form a number of loose layers on the conductive plate 7.

The conductive plate 7 is then shaken and tilted to cause the layers of dielectric spheres 9 to settle to produce a single close packed layer of dielectric spheres 9 on the conductive plate 7 and a number of loose dielectric spheres 9 resting on top of this layer 4. The loose dielectric spheres 9 are then swept off the triplate structure 6 to leave a single close packed layer of dielectric spheres 9 resting on the conductive plate 7 as shown in Figure 2B. The triplate structure 6 is then exposed to ultra-violet light to cure the adhesive and bond all of the dielectric spheres 9 together.

A substrate 10 bearing a triplate central conductor 11 is then placed on top of the layer of dielectric spheres 9. Because the dielectric spheres 9 all have the same diameter the substrate 10, and thus the central conductor 11 are held parallel to and at a known distance from the conductive plate 7.

More dielectric spheres 12 having the same diameter as the dielectric spheres 9 and coated with an ultra-violet curing adhesive are then placed on top of the substrate 10 and central conductor 11, these form a number of loose layers on top of the substrate 10 and central conductor 11, as shown in Figure 2D.

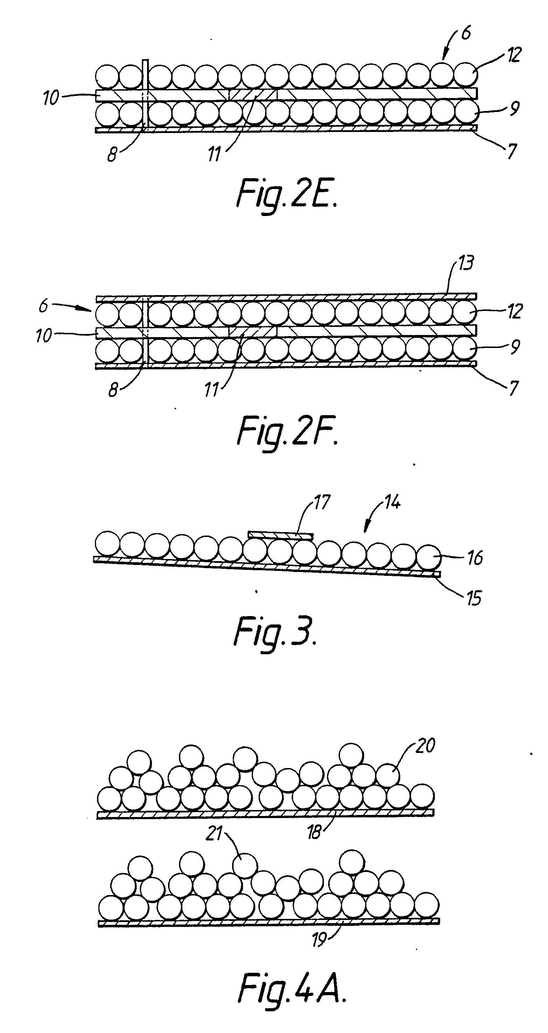

The triplate structure 6 is then shaken and tilted to cause the layers of dielectric spheres 12 to settle and form a single close packed layer of dielectric spheres 12 with a number of loose dielectric spheres 12 resting upon it. These loose dielectric spheres 12 are then swept off to leave a single close packed layer of dielectric spheres 12 resting on the substrate 10 and central conductor 11, as shown in Figure 2E. The triplate structure 6 is then exposed to ultra-violet light to cure the adhesive and bond all of the dielectric spheres 12 together.

A second conductive plate 13 is then placed in top of the layer of dielectric spheres 12 to form the second ground plane of the completed triplate structure as shown in Figure 2F. The second conductive plate 13 is then held parallel to and at a known distance from the first conductive plate 7 and the centre conductor 11 and at the same distance from the central conductor 11 as the first conductive plate 7 by the spheres 9 and 12. The two conductive plates 7 and 13 are then secured together using the support 8.

The same technique can also be used to produce a stripline structure as shown in Figure 3. The stripline 14 comprises a conductive plate 15 acting as a ground plane and bearing a close packed layer of dielectric spheres 16 which in turn bear a conductor 17. The stripline structure 14 is formed by carrying out the process described above with reference to Figures 2A and 2B and then placing the conductor 17 on top of the spheres 16.

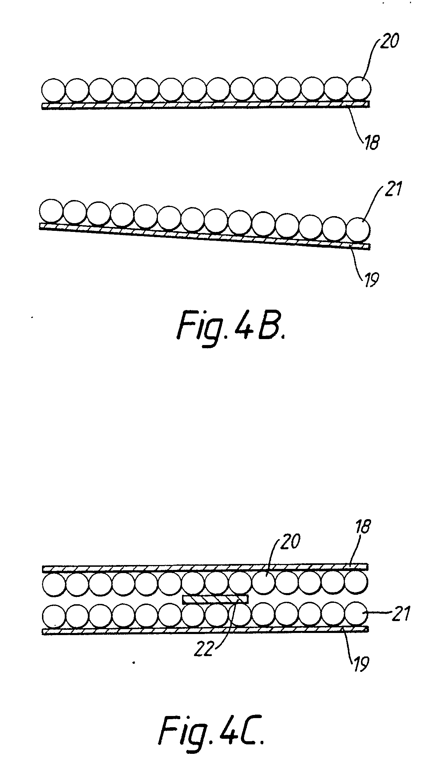

Another method of forming a triplate structure is to take a pair of conductive plates 18 and 19 and place a number of dielectric spheres all having the same diameter and coated with ultra-violet curing adhesive 20 and 21 on each of the conductive plates 18 and 19, as shown in Figure 4A. The conductive plates 18 and 19 are then shaken and tilted to cause the dielectric spheres 20 and 21 to settle into a single close packed layer on each of the conductive plates 18 and 19 and a number of loose layers on top of these close packed layers. The loose dielectric spheres 20 and 21 are then swept off and ultra-violet light is shone onto the dielectric spheres 20 and 21, causing the adhesive to cure and bond together the spheres 20 and 21 and the conductive plates 18 and 19 as shown in Figure 4B.

The conductive plates 18 and 19 are then placed on either side of a conductor 22 with the spheres 19 and 20 in contact with the conductor 22. They then form a triplate structure as shown in Figure 4C with the dielectric spheres 19 and 20 holding the conductive plates 18 and 19, which form the ground planes of the triplate, parallel to and at a fixed distance from the conductor 22 which forms the central conductor of the triplate.

The use of ultra-violet cured adhesive is not essential, other forms of adhesive such as heat cured adhesive could be used or it may be preferred to use no adhesive.

## Claims

1. A signal carrier comprising a first conductor (7) and a second conductor (11) characterised in that the first and second conductors are separated by a first layer of dielectric spheres (9), all the spheres (9) being of substantially equal diameter.

2. A signal carrier as claimed in Claim 1 in which the signal carrier is a stripline structure, the first conductor (7) forms the stripline ground plane and the second conductor (11) acts as the stripline signal conductor.

3. A signal carrier as claimed in Claim 1 in which; the signal carrier is a triplate structure; the first conductor (9) is substantially planar and forms a first one of the triplate ground planes and the second conductor (11) forms the triplate centre conductor and also including a third substantially planar conductor (13) on the opposite side of the second conductor to the first conductor and forming the second triplate ground plane, separated from the second conductor by a second layer of dielectric spheres (12) having substantially the same diameter as those of the first layer.

4. A method of forming a stripline structure comprising: forming a ground plane from a conductive plate; placing upon the ground plane a plurality of dielectric spheres of substantially uniform diameter and coated with an ultra violet curing adhesive; arranging the spheres to form a layer of substantially uniform thickness; exposing the spheres to ultra violet light; and placing a conductor on the layer of spheres.

5. A method of forming a triplate structure comprising: forming two ground planes from two respective conductive plates; placing upon each ground plane a plurality of dielectric spheres of substantially uniform diameter and coated with ultra violet curing adhesive; arranging the spheres on each ground plane to form a layer of substantially uniform thickness; exposing the spheres to ultra violet light; and arranging each ground plane about a centre conductor such that the spheres attached to each ground plane determine the separation of each ground plane from the centre conductor.

6. A stripline structure formed by the method of Claim 4.

7. A triplate structure formed by the method of Claim 5.

Fig.1.

Fig.2A.

Fig.2B.

Fig.2C.

Fig.2D.

Fig.2E.

Fig.2F.

Fig.3.

Fig.4A.

Fig. 4B.

Fig. 4C.